# EUROPEAN PATENT APPLICATION

(11) **EP 4 742 687 A1**
(43) Date of publication of application: **13.05.2026**
(21) Application number: 24836012.5
(22) Date of filing: 01.07.2024
(51) Int. Cl.: H04N 21/845, G06T 9/00, G06T 15/00, H03M 7/30, H04N 21/84

(54) **INFORMATION PROCESSING DEVICE, REPRODUCTION DEVICE, INFORMATION PROCESSING METHOD, AND PROGRAM**

(30) Priority: 05.07.2023 JP 2023110826
(71) Applicant: Canon Kabushiki Kaisha, Tokyo, 146-8501 (JP)
(72) Inventor: SUNEYA, Toru, Tokyo 146-8501 (JP)
(74) Representative: Canon Europe Limited
(86) International application number: PCT/JP2024/023737
(87) International publication number: WO 2025/009499

(57) **Abstract**

An obtaining means obtains first data of a first three-dimensional object and second data of a second three-dimensional object different from the first three-dimensional object. A first generating means generates arrangement information for arranging the first three-dimensional object and the second three-dimensional object in a same coordinate system. A second generating means generates metadata that is common for the first three-dimensional object and the second three-dimensional object. A third generating means generates a first track that manages the first data, a second track that manages the second data, and a third track that manages the metadata. A fourth generating means generates a single file that stores the first track, the second track, the third track, the first data, the second data, the arrangement information, and the metadata.

## Description

### TECHNICAL FIELD

The present invention relates to an information processing apparatus, a playback apparatus, an information processing method, and a program.

### BACKGROUND ART

Methods that use computer graphics are known as conventional methods for generating 3D object data. However, in recent years, methods for obtaining 3D object data by scanning the shapes real objects, people, and the like using dedicated devices, studios, and the like are being used more often.

Efforts are also underway for data utilization in which multiple items of 3D object data generated or obtained in such a manner are arranged within the same three-dimensional space. For example, in the field of autonomous driving or driver assistance, progress is being made in developing systems for updating road information in real time by obtaining 3D object data of objects around roads, by in-vehicle remote sensing devices such as LiDAR (Light Detection And Ranging or Laser Imaging Detection and Ranging), and displaying the 3D object data superimposed onto a dynamic map.

Meanwhile, MPEG (Moving Picture Experts Group), which is a group under the ISO (International Organization for Standardization) and the IEC (International Electrotechnical Commission), is advancing the standardization of specifications for encoding 3D object data such as point clouds or meshes, and file format standards for storing encoded 3D object data.

Patent Literature (PTL) 1 discloses a technique that makes it possible to, for example, change the quality of a portion of 3D object data by spatially dividing 3D object data encoded through G-PCC (Geometry based Point Cloud Compression), which is being standardized by MPEG, and then generating position information on the positions of the divided portions of the 3D object data in a three-dimensional space, and grouping information indicating that the divided portions belong to the same group.

### CITATION LIST

### PATENT LITERATURE

PTL 1: International Publication No. 2020/137642

### SUMMARY OF INVENTION

### TECHNICAL PROBLEM

However, although the technique described in PTL 1 discloses an aspect for dividing a single item of 3D object data, an aspect for storing multiple different items of 3D object data in a single file is not considered.

Furthermore, glTF, which is a format for expressing 3D models, writes the structure and configuration of a three-dimensional space in JSON format, and makes it possible to arrange a plurality of items of 3D object data in the same three-dimensional space. However, glTF is a specification in which the three-dimensional space and object data are associated with each other using a URI, and it has been necessary to read out and analyze individual items of object data in order to determine whether that object data is in a data format that can be displayed.

An object of the present invention is to utilize a single file that stores information for displaying a plurality of items of three-dimensional object data in the same coordinate system.

### SOLUTION TO PROBLEM

To achieve the object of the present invention, an information processing apparatus according to one embodiment has the following configuration, for example. In other words, An information processing apparatus comprises: an obtaining means for obtaining first data of a first three-dimensional object and second data of a second three-dimensional object different from the first three-dimensional object; a first generating means for generating arrangement information for arranging the first three-dimensional object and the second three-dimensional object in a same coordinate system; a second generating means for generating metadata that is common for the first three-dimensional object and the second three-dimensional object; a third generating means for generating a first track that manages the first data, a second track that manages the second data, and a third track that manages the metadata; and a fourth generating means for generating a single file that stores the first track, the second track, the third track, the first data, the second data, the arrangement information, and the metadata.

### ADVANTAGEOUS EFFECTS OF INVENTION

A single file that stores information for displaying a plurality of items of three-dimensional object data in the same coordinate system is utilized.

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

The accompanying drawings, which are incorporated in and constitute a part of the specification, illustrate embodiments of the invention and, together with the description, serve to explain principles of the invention.
FIG. 1 is a block diagram illustrating an example of the functional configuration of an information processing apparatus according to a first embodiment.
FIG. 2 is a flowchart illustrating an example of file generation processing according to the first embodiment.
FIG. 3 is a diagram illustrating the structure of a file generated by the information processing apparatus according to the first embodiment.
FIG. 4 is a diagram illustrating arrangement information according to the first embodiment.
FIGS. 5A and 5B are diagrams illustrating light source information according to the first embodiment.
FIG. 6 is a diagram illustrating field of view information according to the first embodiment.
FIG. 7 is a block diagram illustrating an example of the functional configuration of a playback apparatus according to the first embodiment.
FIG. 8 is a flowchart illustrating an example of rendering processing according to the first embodiment.
FIG. 9 is a diagram illustrating the structure of a file generated in a variation on an information processing apparatus.
FIG. 10 is a block diagram illustrating an example of the hardware configuration of an apparatus according to a second embodiment.

### DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

### [First Embodiment]

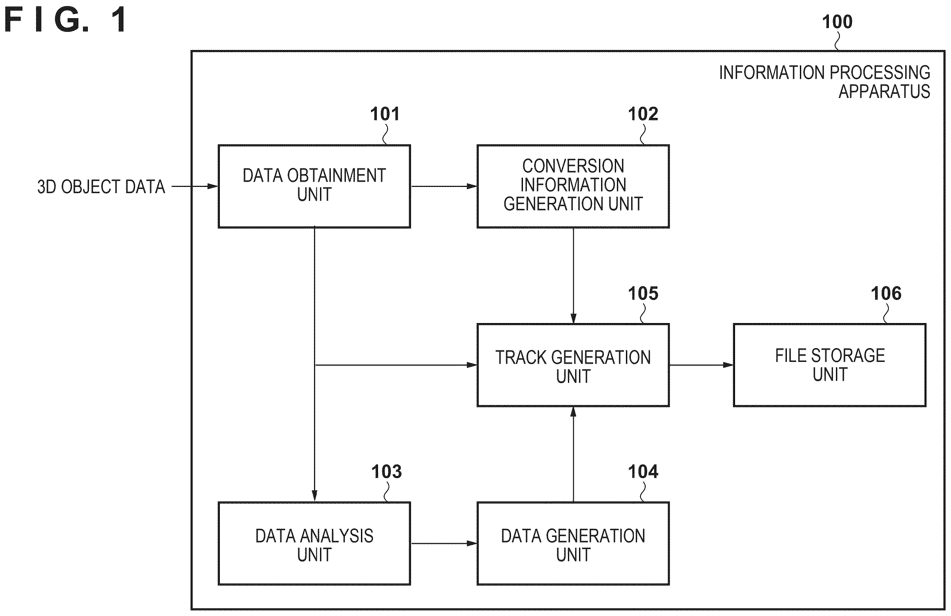

The functional configuration of an information processing apparatus according to one embodiment of the present invention will be described with reference to FIG. 1. FIG. 1 is a block diagram illustrating the functional configuration of an information processing apparatus 100 according to a first embodiment. The information processing apparatus 100 according to the present embodiment includes a data obtainment unit 101, a conversion information generation unit 102, a data analysis unit 103, a data generation unit 104, a track generation unit 105, and a file storage unit 106.

The data obtainment unit 101 obtains encoded three-dimensional (3D) object data such as encoded point cloud data or 3D mesh data. The data obtainment unit 101 can obtain various types of data from an external device (not shown), for example. In the present embodiment, the 3D object data obtained by the data obtainment unit 101 is encoded, and includes information used when decoding the 3D object data (decoding information). The decoding information according to the present embodiment is metadata including information related to decoding, and includes a parameter set (profile information) referred to by a decoder during decoding. In the present embodiment, the "information related to decoding" includes, as the parameter set, information indicating whether the 3D object data can be decoded, and a determination is made as to whether decoding is possible by the parameter set being analyzed.

Here, the decoding information is information referred to in the decoding, such as a profile or level that identifies the tool set used during the encoding, which can be added using a publicly-known encoding technique; as such, detailed descriptions thereof will be omitted. The data analysis unit 103 extracts the decoding information by analyzing the obtained 3D object data. Hereinafter, a 3D object represented by such 3D object data may be referred to simply as an "object".

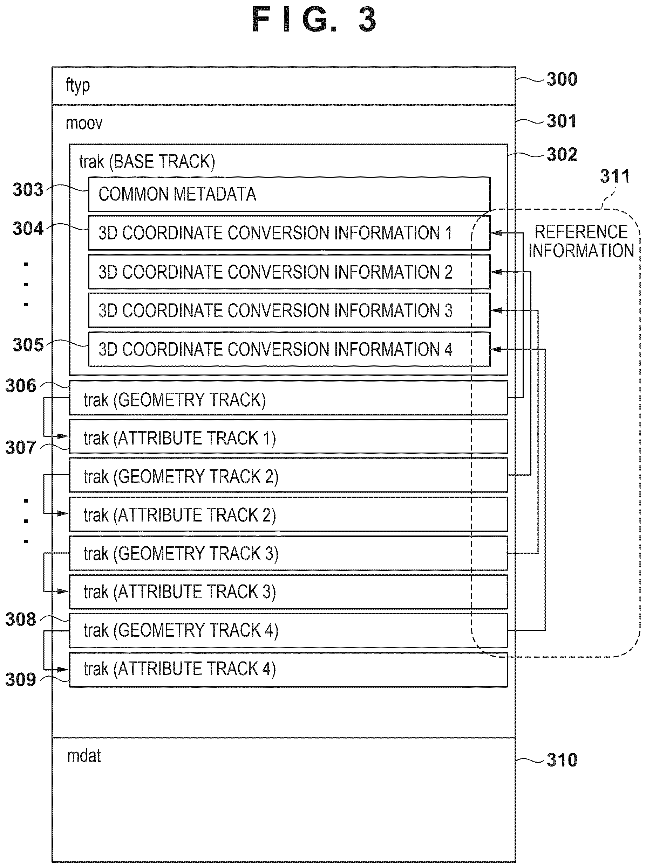

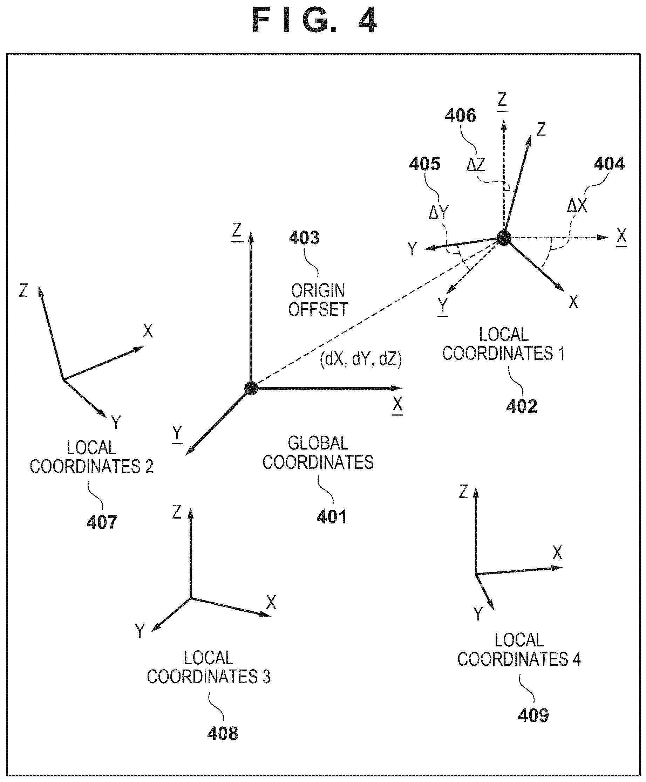

The conversion information generation unit 102 generates arrangement information for arranging the obtained 3D object data in a given three-dimensional space. The arrangement information according to the present embodiment is 3D coordinate conversion information for converting local coordinates of two or more 3D objects into coordinates in the same coordinate system, respectively; detailed descriptions thereof will be given later with reference to FIGS. 3 and 4. In the present embodiment, local coordinates of each 3D object are generated from corresponding 3D object data obtained by the data obtainment unit 101, and these local coordinates are then converted into global coordinates in the same coordinate system.

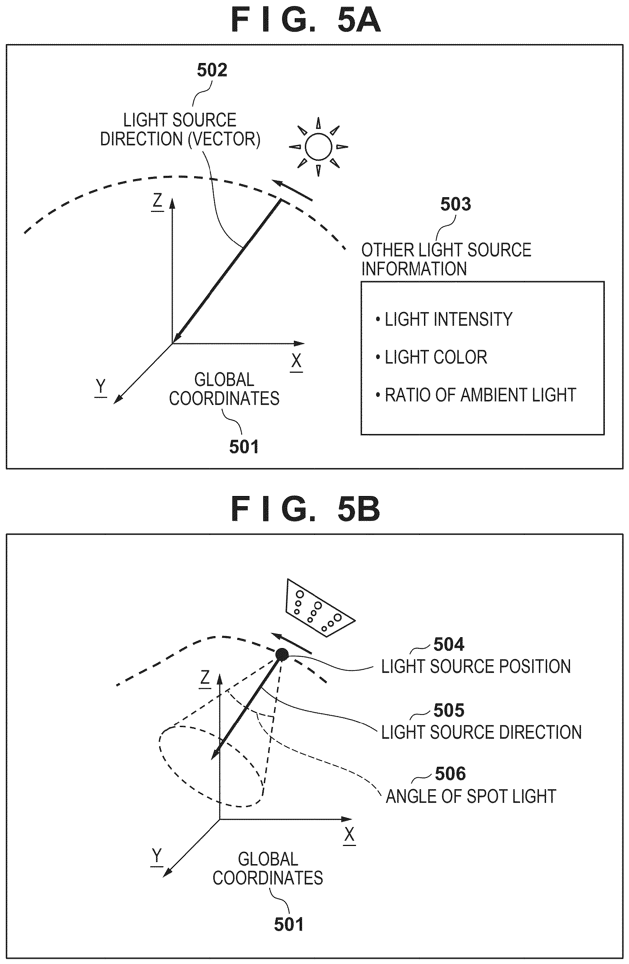

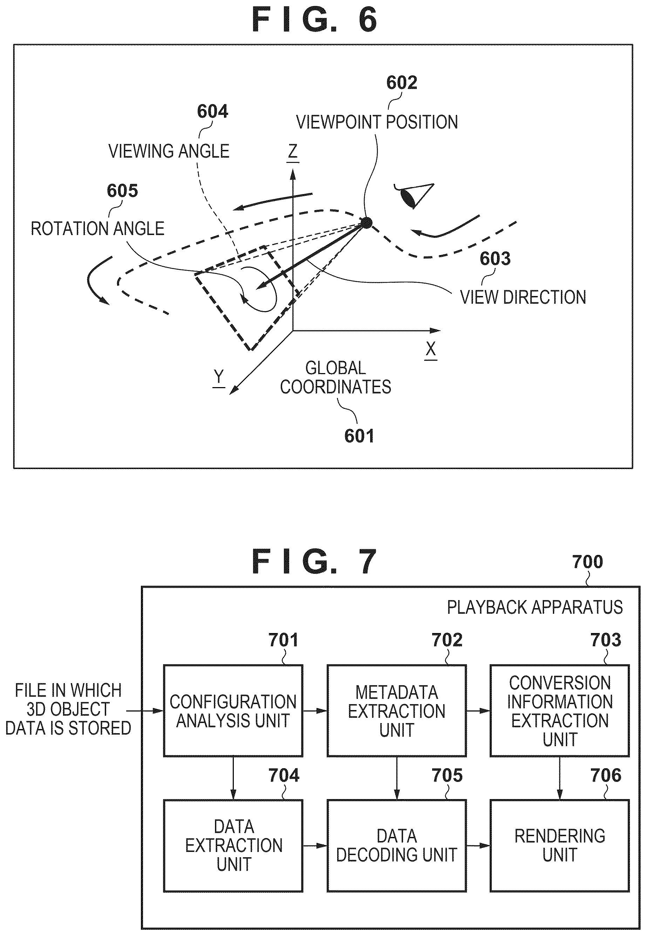

The data generation unit 104 generates metadata for managing the decoding information extracted by the data analysis unit 103. In the present embodiment, a function for generating common metadata, such as that indicated by 303 in FIG. 3 (described later), is provided, under the assumption that the obtained decoding information for the plurality of items of 3D object data is common. The common metadata according to the present embodiment includes common information used for rendering each object, and the decoding information. This common information is assumed to be light source information or field of view information, for example, and this will be described in detail later with reference to FIGS. 5A, 5B, and 6.

The track generation unit 105 according to the present embodiment generates a trak block (a track; described later) as a block for managing various types of data in a file generated by the information processing apparatus 100. Here, the track generation unit 105 can generate a track that stores information on the obtained 3D object data and a track that manages the common metadata generated by the data generation unit 104.

The file storage unit 106 generates a file storing the plurality of items of 3D object data obtained and the track generated by the track generation unit 105.

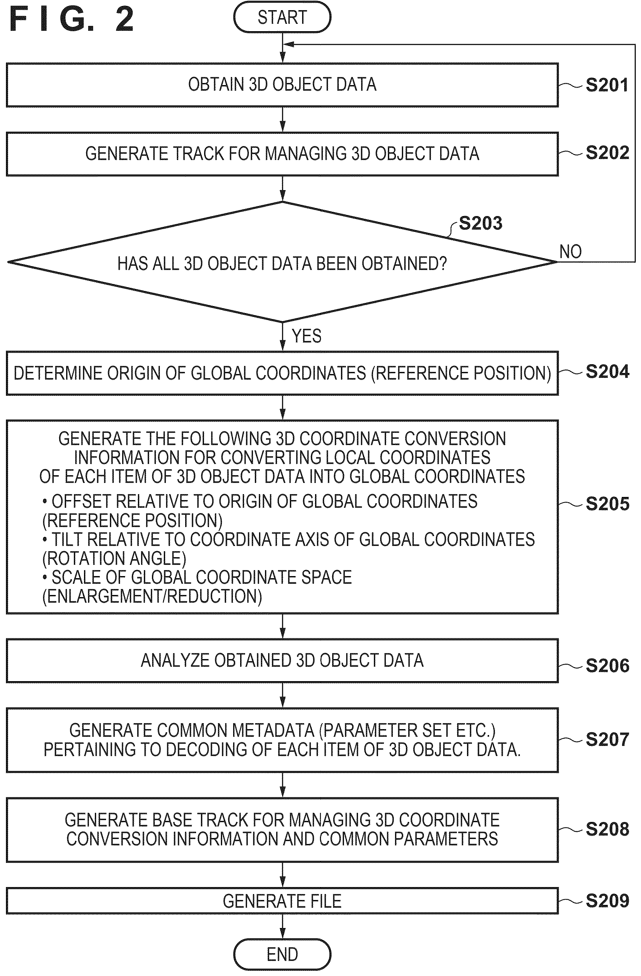

A sequence of processing from obtaining the 3D object data to generating a file, performed by the information processing apparatus 100 according to the present embodiment, will be described next with reference to FIG. 2. FIG. 2 is a flowchart illustrating an example of the file generation processing performed by the information processing apparatus according to the present embodiment. The processing according to FIG. 2 is started, for example, when 3D object data is sent to the information processing apparatus 100 from an external device (not shown).

In S201, the data obtainment unit 101 obtains the 3D object data. Here, the data obtainment unit 101 obtains the 3D object data from an external device. In S202, the track generation unit 105 generates a track for managing the obtained 3D object data. The track for managing the 3D object data will be described later with reference to FIG. 3.

In S203, the data obtainment unit 101 determines whether all the object data to be stored in the file has been obtained in S201. The sequence moves to S204 if all the object data has been obtained, and returns to S201 if not. Here, the data obtainment unit 101 is configured to obtain a predetermined number of items of 3D object data, for example, and may determine whether the predetermined number of items of 3D object data have been obtained. For example, the data obtainment unit 101 may make the determination by receiving a signal indicating whether all the 3D object data has been sent from an external device that sends the 3D object data.

In S204, the conversion information generation unit 102 sets an origin (a reference position) in a coordinate system (a global coordinate system) of a given three-dimensional space in which the obtained 3D object data is to be arranged. This global coordinate system is the coordinate system used when displaying each of the 3D objects in the coordinate system, and can be set as desired. For example, the global coordinate system may be a coordinate system set on the basis of geographical coordinates specified by GPS (Global Positioning System). The global coordinate system may also be a coordinate system used to display the coordinates of each of spaces defined by space IDs. In this case, it is assumed that a predetermined position in the space designated by the space ID in the global coordinate system (for example, one of the corners of the space, such as a voxel designated by the space ID) is expressed as a reference point of the space ID.

The space ID according to the present embodiment is identification information that specifies a spatial position in the same global coordinate system. In other words, in the present embodiment, the position of a given three-dimensional space in the real world can be uniquely specified by the space ID, and thus a positional relationship among spaces specified by a plurality of space IDs can also be uniquely specified. Accordingly, when using the space ID as the reference position, the reference point of a different space ID for each item of 3D object data can be set as the reference position.

Furthermore, although the present embodiment assumes conversion such that all the 3D objects to be processed are arranged in the same global coordinate system, the present embodiment is not particularly limited thereto. For example, the 3D objects may be divided into several groups, and the local coordinates of each 3D object may be converted into coordinates of a coordinate system of a different three-dimensional space for each group.

The present embodiment assumes that the spatial position in the common global coordinate system is specified by the space ID. However, the positions in the coordinate systems of different three-dimensional spaces may be specified by respective space IDs. For example, a space ID may be assigned for each of levels of a structure, and a coordinate system originating from a corner of the level may be referenced.

In S205, the conversion information generation unit 102 generates 3D coordinate conversion information. The 3D coordinate conversion information according to the present embodiment includes information indicating a position in the global coordinate system, an orientation in the global coordinate system, and a size in the global coordinate system, for the corresponding 3D object. Here, the 3D coordinate conversion information includes, for example, an offset of the local coordinates relative to the origin of the global coordinates (an amount of shift in the origin), a tilt (rotation angle) of the coordinate axis relative to the global coordinates, scale information (magnification/reduction) with respect to the global coordinate system, and the like, calculated for each object.

In S206, the data analysis unit 103 extracts the decoding information by analyzing the obtained 3D object data. In S207, the data generation unit 104 generates common metadata including decoding information used for the decoding of each item of the 3D object data.

In S208, the track generation unit 105 generates a track storing the 3D coordinate conversion information and common parameters (a base track). In S209, the file storage unit 106 generates a file storing the plurality of items of 3D object data obtained and the track generated by the track generation unit 105, after which the processing illustrated in FIG. 2 ends.

Note that the format of the encoded 3D object data may be any format that includes geometry information, which is position information in the three-dimensional space, and the data format is not particularly limited. For example, the 3D object data used in the present embodiment may be in point cloud data format, 3D mesh data format, or the like.

A specific example of a file generated by the sequence of processing illustrated in FIG. 2 will be described next with reference to FIG. 3. FIG. 3 is a schematic diagram illustrating an example of the internal structure of the file generated by the information processing apparatus 100 according to the present embodiment. Although the file format illustrated in FIG. 3 will be described as being based on the ISO Base Media File Format (referred to as ISOBMFF hereinafter), which is a basic specification for media files standardized by MPEG, the file format is not particularly limited thereto, as long as the data can be stored in the same manner.

A file 300 generated by the information processing apparatus 100 according to the present embodiment includes a plurality of boxes identified by four-character identifiers, and information for each of different purposes is stored in each of the boxes. Hereinafter, each box will be expressed by the four-character identifier assigned to that box. The file 300 according to the present embodiment includes ftyp, moov 301, and mdat 310 as boxes. ftyp (FileTypeBox) has a four-character identifier called a brand, for identifying the type/subtype of the image file.

the moov (MovieBox) 301 includes a plurality of trak (TrackBox) boxes. The moov 301 according to the present embodiment is capable of storing metadata pertaining to data such as a moving image, an image, or the like, and the trak box (the track) is capable of storing data indicating arrangement positions of data such as a moving image, audio, or the like (index information). Here, the moov 301 contains a total of nine tracks, including a base track 302 and tracks 306 to 309. Here, geometry tracks 1 to 4, which manage coordinate information for expressing the shape of the object, and attribute tracks 1 to 4, which manage attribute information of the object such as the colors of surfaces of the object or the reflectance of light, are stored in the moov 301.

In the example in FIG. 3, information corresponding to four independent objects 1 to 4 is stored in the moov 301, and these are respectively indicated by the geometry tracks 1 to 4 and the attribute tracks 1 to 4. In other words, the geometry track 1 (306) and the attribute track 1 (307) are included as blocks that store information corresponding to the object 1, for example. Note that the association between a geometry track and an attribute track is defined by generating reference information to the attribute track in the geometry track.

Note that the real data of the coordinate information and the attribute information managed by these tracks is stored in an mdat (MediaDataBox) 310. In other words, the information stored in the moov 301 is index information indicating a reference location of the real data stored in the mdat 310, and although the mdat 310 is illustrated at a small size in FIG. 3 for the sake of explanation, the corresponding data stored in the mdat 310 is much larger than the information stored in the corresponding track.

The base track 302 stores common metadata 303 and the 3D coordinate conversion information corresponding to each object. In the example in FIG. 3, 3D coordinate conversion information 1 to 4 corresponding to the objects 1 to 4, respectively, is information for arranging object data at global coordinates in a common three-dimensional space (called a virtual space hereinafter). Here, local coordinates are managed as coordinate information in the geometry track of each object. Accordingly, as described above, the 3D coordinate conversion information includes an offset of the local coordinates relative to the origin of the global coordinates (an amount of shift in the origin), a tilt (rotation angle) of the coordinate axis relative to the global coordinates, scale information (magnification/reduction) with respect to the global coordinate system, and the like, calculated for each object.

A specific example of the 3D coordinate conversion information will be described here with reference to FIG. 4. FIG. 4 is a schematic diagram illustrating an example of the 3D coordinate conversion information according to the present embodiment. In FIG. 4, global coordinates 401 are a single set of spatial coordinates in the virtual space, and the local coordinates 1 to 4 are unit vectors used when expressing the coordinate system of the local coordinates of the objects 1 to 4, respectively. The local coordinates 1 (402) will be described hereinafter.

An origin offset 403 is information indicating, as offset values, the position of the origin of the local coordinates 1 from the origin of the global coordinates 401 in the virtual space, and can be indicated by offset values for three axes (dx,dy,dz) in a three-dimensional orthogonal coordinate system illustrated in FIG. 4.

Additionally, ΔX (404), ΔY (405), and ΔZ (406) indicated in FIG. 4 is information indicating the tilt (rotation angle) of the coordinate axis of the local coordinates with respect to the global coordinates 401. This rotation angle is indicated by the roll angle/pitch angle/yaw angle in the three-dimensional orthogonal coordinate system in the example in FIG. 4, but a different method may be used as long as the rotation angle can be expressed, e.g., using a quaternion.

In the example in FIG. 4, when expressing each item of 3D object data in the virtual space, the scale information (magnification/reduction) is added in order to set the size of each item of the 3D object data to a desired ratio. The scale information may be set for each of the X, Y, and Z directions in each local coordinate system, for example. The value of the scale information can be defined by an integer, a fraction, or the like. The scale information may be set on the basis of inputs made by a user, and may be added to the 3D object data obtained by the data obtainment unit 101, for example.

Although the local coordinates 1 have been described thus far, various types of 3D coordinate conversion information can also be generated for the other local coordinates 2 to 4 in the same manner. Relative arrangement information of the plurality of items of 3D object data in the virtual space can be determined by generating the 3D coordinate conversion information for each object in this manner.

According to such a configuration, a plurality of different items of 3D object data can be stored in a single file, and thus the technique can be implemented using only one file when a plurality of 3D objects are used in combination. For example, 3D object data of a background and 3D object data of a person may be combined, and a part of a dynamic map expected to be used in autonomous driving or the like may be combined with 3D object data obtained by LiDAR almost in real time.

Note that each item of 3D object data may have a different framerate, and static 3D object data and dynamic 3D object data may even be used in combination with each other. Note that when static 3D object data is stored in a file, a form is conceivable in which the data is stored as items in iloc and iinf boxes (not shown), rather than in the trak box.

Although the 3D coordinate conversion information is described as being stored in the base track as illustrated in FIG. 3, the storage location is not particularly limited thereto. For example, the 3D coordinate conversion information may be stored in tracks corresponding to the respective objects rather than in the common metadata, such as each of the geometrics 1 to 4.

It is assumed here that the virtual space in which the plurality of items of 3D object data are arranged is a virtual space set by the user. However, as described above, the global coordinates may be a coordinate system set on the basis of geographical coordinates specified by GPS, and may be a predefined coordinate system used when using the space ID.

An example of metadata aside from the decoding information, stored in the common metadata 303 indicated in FIG. 3, will be described next with reference to FIGS. 5A, 5B, and 6. FIGS. 5A and 5B are schematic diagrams illustrating an example of light source information in the virtual space according to the present embodiment. In FIGS. 5A and 5B, FIG. 5A illustrates an example in which the light source is the sun, and FIG. 5B illustrates an example in which the light source is indoor lighting. For example, in FIG. 5A, where the sun is assumed to be the light source, in global coordinates 501, which are the coordinates in the virtual space, the light source is a parallel light source, and the direction of the light source (the sun) is defined by a light source direction 502. Furthermore, other light source information 503 may include the intensity of the light (total light flux and illumination level), the color of the light (color temperature), the ratio of ambient light, which is light incident uniformly from all directions, to the entire light source, and the like.

An example of the light source information when the light source is indoor lighting, as in the case in FIG. 5B, will be described next. When indoor lighting is used, a light source position 504 indicating the position (spatial coordinates) of the light source in the global coordinates 501, a light source direction 505 indicating the direction of the light source, a light source spot angle 506 indicating the light distribution angle of spot light when the light source is spot light, and the like may be used as the light source information.

A plurality of light sources may be present in a single virtual space, in which case light source information corresponding to each light source is stored. Furthermore, if the light source changes, e.g., if the light source moves over time, the intensity or color changes, or the like, the light source information may be stored as timed metadata so as to be capable of being handled as dynamic information having a time axis.

Next, FIG. 6 is a schematic diagram illustrating an example of field of view information of the virtual space according to the present embodiment. In FIG. 6, the field of view information is expressed by a viewpoint position 602, which indicates the spatial coordinates of a viewpoint (a camera) in global coordinates 601, which are coordinates of the virtual space; a view direction 603, which indicates the direction of view from the viewpoint position 602; a viewing angle 604, which indicates the angle of view when viewing in the direction indicated by the view direction 603; and a rotation angle 605, which indicates the rotation angle from when the viewing angle 604 is horizontal. The viewpoint position 602, the view direction 603, the viewing angle 604, and the rotation angle 605 may change over time, and thus the information may be stored as timed metadata so as to be capable of being handled as dynamic information having a time axis. Additionally, information indicating whether the viewpoint is stereo may be stored as the field of view information, and a plurality of items of field of view information may be stored such that the viewpoint can be selected.

The parameters of the various types of information constituting the foregoing field of view information will be described next. The viewpoint position 602 can be indicated by three axis parameters (X,Y,Z) in orthogonal coordinates. The view direction 603 is vector information from the viewpoint position 602, and can be indicated by three axis parameters (X,Y,Z) using the viewpoint position 602 as a reference position. In the case of a rectangular region such as that illustrated in FIG. 6, the viewing angle 604 can be indicated by an angle in each of the horizontal direction and the vertical direction. The rotation angle 605 can be indicated as an angle to the right or to the left when viewed from the viewpoint side, taking as a reference a state in which the horizontal edge of the rectangular region indicated by the viewing angle 604 is parallel to an XY plane.

In this manner, the present embodiment assumes that light source information, field of view information, and the like can be stored in addition to the decoding information as common metadata. Here, if the decoding information, which is static information, is stored in the ISOBMFF file, that information may be written in a sample description box (SampleDescriptionBox) in the base track. It is assumed here that a "sample" is a collection of data associated with a predetermined unit time of the video, audio, or 3D object to be stored in the ISOBMFF file. A collection of data to undergo playback processing in a unit time, expressed, for example, as a framerate in the case of video, a sampling rate in the case of audio, or the like, is used as the sample.

If the light source information or the field of view information is static data, the information may be stored in the sample description box in the same manner as the decoding information; however, because this information does not pertain to the encoded data, the information may be stored in a meta box (MetaBox) in the base track. On the other hand, if the light source information or the field of view information is dynamic data, it is desirable to store the data as timed metadata managed by the base track.

The present embodiment has described, with reference to FIG. 3, a form in which the 3D coordinate conversion information is stored in a base track or in individual geometry tracks. However, if the 3D coordinate conversion information is static information, that information may also be stored in the meta box. In that case, the geometry track can be associated with the 3D coordinate conversion information by defining reference information 311 to the meta box in which the 3D coordinate conversion information is stored in the geometry track, as illustrated in FIG. 3.

In this manner, the location in the file in which the various types of information are stored is not particularly limited, and can be implemented in any form as long as a plurality of objects can be defined in a single file in the same manner.

According to such a configuration, arrangement information for arranging a plurality of three-dimensional objects in the same coordinate system and decoding information indicating whether the objects can be decoded can be generated, and the generated information can be stored in a single file.

A file storing a plurality of items of 3D object data is generated by the information processing apparatus 100 according to the present embodiment. In the present embodiment, a playback apparatus 700 performs playback processing for the 3D object data from the file generated by the information processing apparatus 100. The playback apparatus 700 according to the present embodiment will be described hereinafter with reference to FIGS. 7 to 8. FIG. 7 is a block diagram illustrating an example of the functional configuration of the playback apparatus 700 according to the present embodiment. The playback apparatus 700 includes a configuration analysis unit 701, a metadata extraction unit 702, a conversion information extraction unit 703, a data extraction unit 704, a data decoding unit 705, and a rendering unit 706.

The configuration analysis unit 701 analyzes the file containing the 3D object data and specifies the locations of the various types of data. Here, the configuration analysis unit 701 can specify the location of the common metadata and the 3D object data from the file generated by the information processing apparatus 100.

The metadata extraction unit 702 analyzes the decoding information in the file and determines whether the encoded 3D object data can be decoded. Specifically, the common metadata of the file is analyzed, and whether the 3D object data can be decoded is determined on the basis of the profile information.

The conversion information extraction unit 703 extracts the 3D coordinate conversion information, which is coordinate conversion information for arranging the stored 3D object data in the virtual space.

The data extraction unit 704 extracts encoded data pertaining to the 3D object data, such as moving images, images, or the like, from the file. The encoded data is stored in the mdat 310 described with reference to FIG. 3. Geometry data, which is the encoded real data of the coordinate information constituting the 3D object data, and attribute data, which is the encoded real data of the attribute information, can be extracted from this encoded data.

The data decoding unit 705 decodes the encoded geometry data and attribute data on the basis of the result of the determination by the metadata extraction unit 702.

The rendering unit 706 has a function for rendering the 3D object data at the predetermined coordinates in the virtual space on the basis of the 3D coordinate conversion information extracted by the conversion information extraction unit 703. Hereinafter, rendering the 3D object data stored in the file in the virtual space in this manner will be referred to as "playback".

Note that the field of view information is necessary for rendering the 3D object data. Accordingly, for example, at least some of the various types of field of view information (the viewpoint position 602, the view direction 603, the viewing angle 604, and the rotation angle 605) described with reference to FIG. 6 may be stored in the file as the common metadata in advance. In that case, the metadata extraction unit 702 can identify the 3D object data to be rendered and the region by reading out the field of view information from the common metadata.

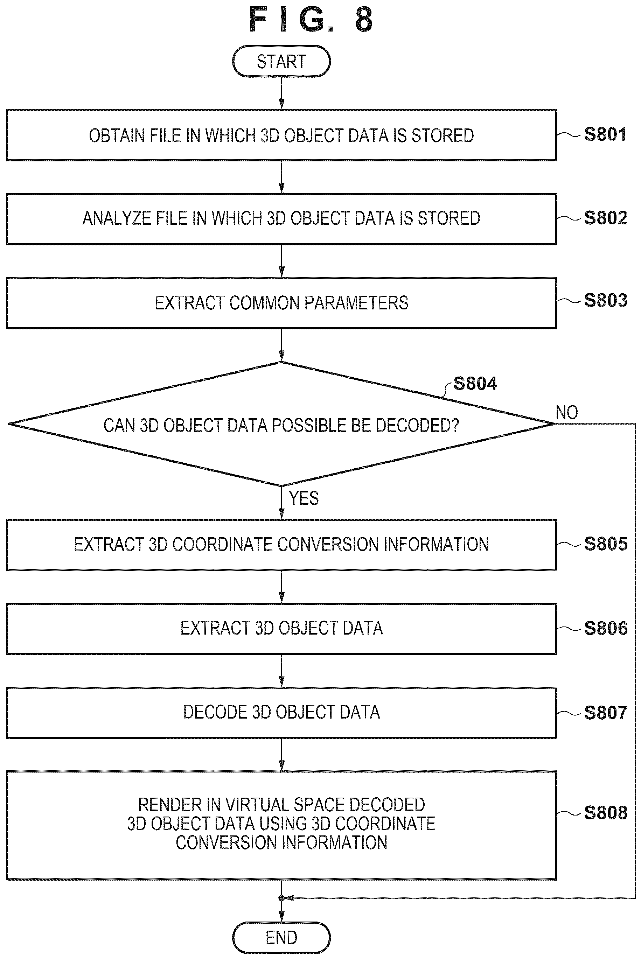

A sequence of processing from obtaining the file in which the 3D object data is stored to rendering the 3D object data, performed by the playback apparatus according to the present embodiment, will be described next with reference to FIG. 8. FIG. 8 is a flowchart illustrating an example of playback processing performed by the playback apparatus according to the present embodiment.

In S801, the configuration analysis unit 701 obtains the file storing the encoded 3D object data. In S802, the configuration analysis unit 701 analyzes the obtained file in which the 3D object data is stored.

In S803, the metadata extraction unit 702 extracts profile information stored as the common parameters of the 3D object data. In S804, the metadata extraction unit 702 analyzes the profile information and determines whether the 3D object data stored in the file can be decoded. If the data can be decoded, the sequence moves to S805, and if not, the sequence ends.

In S805, the conversion information extraction unit 703 extracts 3D coordinate conversion information from the file. In S806, the data extraction unit 704 extracts the geometry data and attribute data constituting the 3D object data from the file. In S807, the data decoding unit 705 decodes the extracted 3D object data.

In S808, using the extracted 3D coordinate conversion information, the rendering unit 706 determines position information of the decoded 3D object data in the virtual space, and renders the 3D object data using the predetermined field of view information. At this time, the field of view information may be included in the common parameters as described above, or the playback apparatus 700 may have the field of view information.

### [Variation]

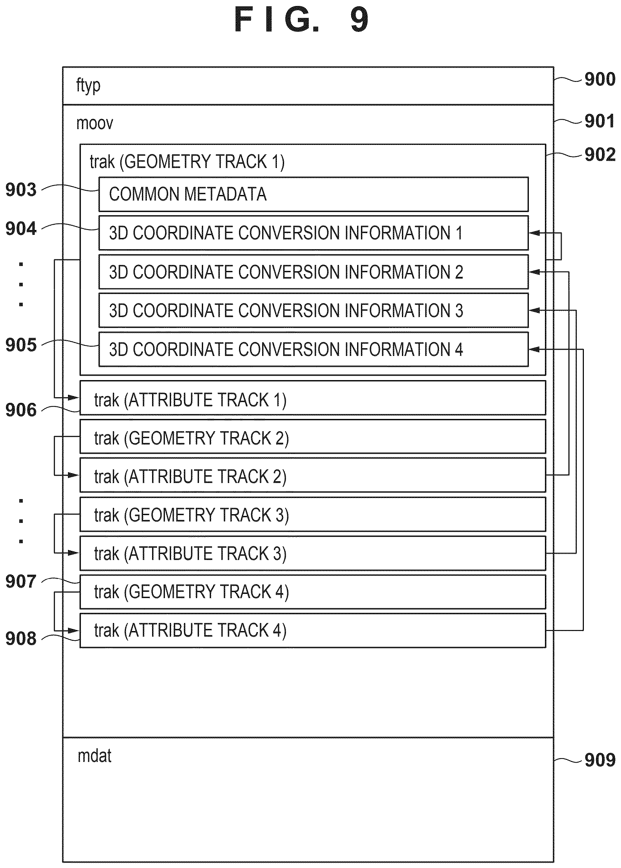

FIG. 3 illustrates an example of a file structure in which the base track 302 for managing common metadata is provided separate from tracks for managing the coordinate information and the attribute information. However, the file structure is not limited thereto, and the common metadata may be stored in the geometry track, for example. Such a variation on the file structure will be described hereinafter with reference to FIG. 9.

A file 900 illustrated in FIG. 9 includes ftyp, moov 901, and mdat 909 as boxes. The basic structure and functions of the file 900 are the same as those of the file 300, and thus redundant descriptions thereof will be omitted.

Like the example in FIG. 3, the moov 901 includes geometry tracks 1 to 4 and attribute tracks 1 to 4 corresponding to the objects 1 to 4. Unlike the file 300, the file 900 does not contain a base track, and the information that had been stored in the base track 302 is stored in the geometry track 1 (902). In other words, in addition to the information that had been stored in the geometry track 306, the geometry track 1 (902) in the file 900 stores the common metadata and the 3D coordinate conversion information that had been stored in the base track 302 in the file 300.

Generally, with media stored in a format based on ISOBMFF, the track to be played back can be selected as desired by the playback apparatus. Accordingly, the file 900 may be generated such that content necessary for playing back the file (e.g., background content) is stored in a track which will absolutely be subjected to analysis processing (here, the geometry track 902).

### [Second Embodiment]

In the foregoing embodiments, each processing unit illustrated in FIG. 1 and the like, for example, is implemented by dedicated hardware. Some or all of the processing units of the information processing apparatus 100 may be implemented by a computer. In the present embodiment, at least some of the processing according to the aforementioned embodiments is executed by a computer.

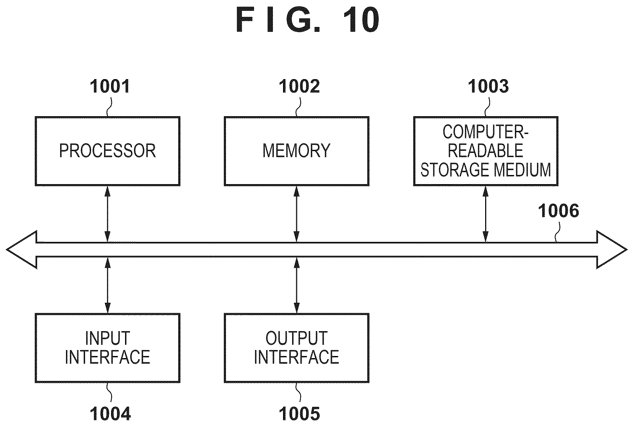

FIG. 10 is a diagram illustrating the basic configuration of a computer. In FIG. 10, a processor 1001 is a CPU, for example, and controls the operations of the computer as a whole. A memory 1002 is a RAM, for example, and temporarily stores programs, data, and the like. A computer-readable storage medium 1003 is, for example, a hard disk, a CD-ROM, or the like, and stores programs, data, and the like on a long-term basis. In the present embodiment, programs that realize the functions of each unit, which are stored by the storage medium 1003, are read out to the memory 1002. Then, the processor 1001 operates according to the programs in the memory 1002 to realize the functions of each unit.

In FIG. 10, an input interface 1004 is an interface for obtaining information from an external device. An output interface 1005 is an interface for outputting information to an external device. A bus 1006 connects the various units described above to enable the exchange of data. The playback apparatus 700 can also be implemented using the same hardware as that illustrated in FIG. 10.

### (Other Embodiments)

The present invention can be implemented by processing of supplying a program for implementing one or more functions of the above-described embodiments to a system or apparatus via a network or storage medium, and causing one or more processors in the computer of the system or apparatus to read out and execute the program. The present invention can also be implemented by a circuit (for example, an ASIC) for implementing one or more functions.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2023-110826, filed July 5, 2023, and the entire content thereof is hereby incorporated by reference herein.

## Claims

1. An information processing apparatus comprising:
an obtaining means for obtaining first data of a first three-dimensional object and second data of a second three-dimensional object different from the first three-dimensional object;
a first generating means for generating arrangement information for arranging the first three-dimensional object and the second three-dimensional object in a same coordinate system;
a second generating means for generating metadata that is common for the first three-dimensional object and the second three-dimensional object;
a third generating means for generating a first track that manages the first data, a second track that manages the second data, and a third track that manages the metadata; and
a fourth generating means for generating a single file that stores the first track, the second track, the third track, the first data, the second data, the arrangement information, and the metadata.

2. The information processing apparatus according to claim 1, **characterized in that** the arrangement information includes information indicating a position in the same coordinate system, information indicating an orientation in the same coordinate system, and information indicating a size in the same coordinate system, for each of the first and second three-dimensional objects.

3. The information processing apparatus according to claim 2, **characterized in that** the information indicating the position of each of the first and second three-dimensional objects in the same coordinate system is a vector between coordinates of an origin of a local coordinate system of each of the first and second three-dimensional objects and coordinates of an origin of the same coordinate system, evaluated by a three-dimensional orthogonal coordinate system.

4. The information processing apparatus according to claim 2 or 3, **characterized in that** the information indicating the orientation of each of the first and second three-dimensional objects in the same coordinate system is a rotation angle between a coordinate axis of a local coordinate system of each of the first and second three-dimensional objects and a coordinate axis of the same coordinate system.

5. The information processing apparatus according to any one of claims 2 to 4, **characterized in that** the information indicating the size of the first and second three-dimensional objects in the same coordinate system is a magnification or a reduction for each of X axis, Y axis, and Z axis values in a local coordinate system of each of the first and second three-dimensional objects and the same coordinate system, evaluated by a three-dimensional orthogonal coordinate system.

6. The information processing apparatus according to any one of claims 1 to 5, **characterized in that** an origin of the same coordinate system is a reference position of a space managed by a space ID.

7. The information processing apparatus according to any one of claims 1 to 6, **characterized in that** the metadata is a parameter set referred to when the first and second three-dimensional objects are decoded.

8. The information processing apparatus according to any one of claims 1 to 7, **characterized in that**:
the third generating means generates, as each of the first, second, and third tracks, a box that stores index information indicating a reference location of data, and
the fourth generating means generates the single file such that the arrangement information and the metadata are managed by an index using a same box among the boxes.

9. The information processing apparatus according to claim 8, **characterized in that**:
the second generating means further generates field of view information indicating a viewpoint in the same coordinate system, and
the fourth generating means generates the single file such that the metadata and the field of view information are managed by an index using a same box among the boxes.

10. The information processing apparatus according to claim 9, **characterized in that** the field of view information is information indicating a viewpoint position in the same coordinate system.

11. The information processing apparatus according to any one of claims 8 to 10, **characterized in that**:
the second generating means further generates light source information indicating a light source in the same coordinate system, and
the fourth generating means generates the single file such that the metadata and the light source information are managed by an index using a same box among the boxes.

12. The information processing apparatus according to claim 11, **characterized in that** the light source information includes at least one of a position, a direction, a light intensity, and a light color of the light source in the same coordinate system.

13. The information processing apparatus according to claim 11 or 12, **characterized in that** in a case where the light source includes a spot light, the light source information includes a light distribution angle of the spot light.

14. The information processing apparatus according to any one of claims 11 to 13, **characterized in that** the light source information is information indicating a plurality of light sources in the same coordinate system.

15. The information processing apparatus according to any one of claims 11 to 14, **characterized in that** in a case where the light source includes ambient light incident uniformly from all directions, the light source information includes information indicating a ratio of the ambient light to an entirety of the light source.

16. A playback apparatus comprising:
an obtaining means for obtaining a single file in which data of a first three-dimensional object and data of a second three-dimensional object are stored;
a first obtaining means for obtaining, from the file, arrangement information for arranging the first three-dimensional object and the second three-dimensional object in a same coordinate system;
a second obtaining means for obtaining, from the file, metadata common to the first three-dimensional object and the second three-dimensional object;
a decoding means for, in a case where the first three-dimensional object and the second three-dimensional object can be decoded, decoding the data of the first three-dimensional object and the data of the second three-dimensional object; and
a rendering means for rendering the first three-dimensional object and the second three-dimensional object in a space in the same coordinate system, based on the arrangement information and the first three-dimensional object and the second three-dimensional object that were decoded by the decoding means.

17. The playback apparatus according to claim 16, **characterized in that** the arrangement information includes information indicating a position in the same coordinate system, information indicating an orientation in the same coordinate system, and information indicating a size in the same coordinate system, for each of the first and second three-dimensional objects.

18. The playback apparatus according to claim 16 or 17, **characterized in that** an origin of the same coordinate system is a reference position of a space managed by a space ID.

19. The playback apparatus according to any one of claims 16 to 18, **characterized in that** the metadata is profile information referred to when decoding the first and second three-dimensional objects.

20. The playback apparatus according to any one of claims 16 to 19, **characterized in that**:
the second obtaining means further obtains, from the file, field of view information indicating a viewpoint in the same coordinate system, and
the rendering means renders the first three-dimensional object and the second three-dimensional object based on the field of view information.

21. The playback apparatus according to any one of claims 16 to 20, **characterized in that**:
the second obtaining means further obtains, from the file, light source information indicating a light source in the same coordinate system, and
the rendering means renders the first three-dimensional object and the second three-dimensional object based on the light source information.

22. An information processing method comprising:
obtaining first data of a first three-dimensional object and second data of a second three-dimensional object different from the first three-dimensional object;
generating arrangement information for arranging the first three-dimensional object and the second three-dimensional object in a same coordinate system;
generating metadata that is common for the first three-dimensional object and the second three-dimensional object;
generating a first track that manages the first data, a second track that manages the second data, and a third track that manages the metadata; and
generating a single file that stores the first track, the second track, the third track, the first data, the second data, the arrangement information, and the metadata.

23. An information processing method comprising:
obtaining a single file in which data of a first three-dimensional object and data of a second three-dimensional object are stored;
obtaining, from the file, arrangement information for arranging the first three-dimensional object and the second three-dimensional object in a same coordinate system;
obtaining, from the file, metadata common to the first three-dimensional object and the second three-dimensional object;
decoding, in a case where the first three-dimensional object and the second three-dimensional object can be decoded, the data of the first three-dimensional object and the data of the second three-dimensional object; and
rendering the first three-dimensional object and the second three-dimensional object in a space in the same coordinate system, based on the arrangement information and the first three-dimensional object and the second three-dimensional object that were decoded.

24. A program for causing a computer to function as each means of the information processing apparatus according to claims 1-15 or the playback apparatus according to claims 16-21.
